# EUROPEAN PATENT APPLICATION

(11) **EP 4 841 898 A1**
(43) Date of publication of application: **18.11.2026**
(21) Application number: 25742057.0
(22) Date of filing: 10.01.2025
(51) Int. Cl.: H04B 1/62, H03F 1/32, H04L 25/49, H03M 1/12, H04B 1/04

(54) **ELECTRONIC DEVICE AND METHOD FOR DIGITAL PRE-DISTORTION**

(30) Priority: 15.01.2024 KR 20240006369; 16.01.2024 KR 20240007073
(71) Applicant: Samsung Electronics Co., Ltd., Suwon-si, Gyeonggi-do 16677 (KR)
(72) Inventor: YANG, Kwonwoo, Suwon-si, Gyeonggi-do 16677 (KR); MIN, Taeyoung, Suwon-si, Gyeonggi-do 16677 (KR); KU, Jungwoo, Suwon-si, Gyeonggi-do 16677 (KR); WOO, Youngyoon, Suwon-si, Gyeonggi-do 16677 (KR); LEE, Seonghyeon, Suwon-si, Gyeonggi-do 16677 (KR)
(74) Representative: Gulde & Partner
(86) International application number: PCT/KR2025/000670
(87) International publication number: WO 2025/155041

(57) **Abstract**

According to an embodiment, a method performed by an electronic device may comprise a step of obtaining a specified number of samples on the basis of an input signal related to a power amplifier (PA) and an output signal related to the PA. The method may comprise a step of identifying first gain information about the input signal with respect to the output signal. The method may comprise a step of performing, for each of power levels of the output signal, a first process for averaging at least some of gain values within a specified power range among the first gain information. The method may comprise a step of performing, for each of the power levels, a second process for estimating gain values outside the specified power range among the first gain information. The method may comprise a step of changing configuration information about a digital pre-distortion (DPD) circuit of the electronic device on the basis of second gain information about the input signal with respect to the output signal.

## Description

### [Technical Field]

The present disclosure relates to a wireless communication system. More specifically, the present disclosure relates to an electronic device and a method for digital pre-distortion (DPD) in the wireless communication system.

### [Background Art]

In a wireless communication system, a digitally modulated signal is amplified through a radio frequency (RF) power amplifier. For transmission of a signal without distortion, a high linear characteristic of the power amplifier is required. In order to provide high linearity of the power amplifier, digital pre-distortion (DPD) for changing an input signal such that an output of the power amplifier is close to an ideal state is used.

The above-described information may be provided as a related art for the purpose of helping understanding of the present disclosure. No argument or decision is made as to whether any of the above description may be applied as a prior art related to the present disclosure.

### [Disclosure]

### [Technical Solution]

According to an embodiment, an electronic device may comprise a digital pre-distortion (DPD) circuit, a digital-to-analog converter (DAC) coupled to the DPD circuit, a power amplifier (PA) coupled to the DAC, an analog-to-digital converter (ADC) coupled to the PA, at least one processor comprising processing circuitry, and memory, comprising one or more storage mediums, storing instructions. The instructions, when executed by the at least one processor individually or collectively, may cause the electronic device to obtain, based on an input signal related to the PA and an output signal related to the PA, a designated number of samples. The instructions, when executed by the at least one processor individually or collectively, may cause the electronic device to, based on the designated number of samples, identify first gain information of the input signal with respect to the output signal. The instructions, when executed by the at least one processor individually or collectively, may cause the electronic device to, with respect to each of power levels of the output signal, perform a first process to average at least a portion of gain values within a designated power range in the first gain information. The instructions, when executed by the at least one processor individually or collectively, may cause the electronic device to, with respect to each of power levels of the output signal, perform a second process to estimate gain values out of the designated power range in the first gain information. The instructions, when executed by the at least one processor individually or collectively, may cause the electronic device to, based on the first process and the second process, obtain second gain information of the input signal with respect to the output signal. The instructions, when executed by the at least one processor individually or collectively, may cause the electronic device to change setting information of the DPD circuit according to the second gain information.

According to an embodiment, a method performed by an electronic device may comprise obtaining, based on an input signal related to a power amplifier (PA) of the electronic device and an output signal related to the PA, a designated number of samples. The method may comprise, based on the designated number of samples, identifying first gain information of the input signal with respect to the output signal. The method may comprise, with respect to each of power levels of the output signal, performing a first process to average at least a portion of gain values within a designated power range in the first gain information. The method may comprise, with respect to each of power levels of the output signal, performing a second process to estimate gain values out of the designated power range in the first gain information. The method may comprise, based on the first process and the second process, obtaining second gain information of the input signal with respect to the output signal. The method may comprise changing setting information of a digital pre-distortion (DPD) circuit of the electronic device according to the second gain information.

According to an embodiment, an electronic device may comprise a digital pre-distortion (DPD) circuit, a digital-to-analog converter (DAC) coupled to the DPD circuit, a power amplifier (PA) coupled to the DAC, an analog-to-digital converter (ADC) coupled to the PA, and at least one processor. The at least one processor may be configured to obtain, based on an input signal related to the PA and an output signal related to the PA, a designated number of samples. The at least one processor may be configured to, based on the designated number of samples, identify first gain information of the input signal with respect to the output signal. The at least one processor may be configured to, with respect to each of power levels of the output signal, perform a first process to average at least part of gain values within a designated power range in the first gain information. The at least one processor may be configured to, with respect to each of power levels of the output signal, perform a second process to estimate gain values out of the designated power range in the first gain information. The at least one processor may be configured to, based on the first process and the second process, obtain second gain information of the input signal with respect to the output signal. The at least one processor may be configured to change setting information of the DPD circuit according to the second gain information.

According to an embodiment, a non-transitory computer readable storage medium may store one or more programs. The one or more programs may comprise instructions, which, when executed by a processor of an electronic device with a digital pre-distortion (DPD) circuit, a digital-to-analog converter (DAC) coupled to the DPD circuit, a power amplifier (PA) coupled to the DAC, and an analog-to-digital converter (ADC) coupled to the PA, cause the electronic device to obtain, based on an input signal related to the PA and an output signal related to the PA, a designated number of samples. The one or more programs may comprise instructions, which, when executed by the processor of the electronic device, cause the electronic device to, based on the designated number of samples, identify first gain information of the input signal with respect to the output signal. The one or more programs may comprise instructions, which, when executed by the processor of the electronic device, cause the electronic device to, with respect to each of power levels of the output signal, perform a first process to average at least a portion of gain values within a designated power range in the first gain information. The one or more programs may comprise instructions, which, when executed by the processor of the electronic device, cause the electronic device to, with respect to each of power levels of the output signal, perform a second process to estimate gain values out of the designated power range in the first gain information. The one or more programs may comprise instructions, which, when executed by the processor of the electronic device, cause the electronic device to, based on the first process and the second process, obtain second gain information of the input signal with respect to the output signal. The one or more programs may comprise instructions, which, when executed by the processor of the electronic device, cause the electronic device to change setting information of the DPD circuit according to the second gain information.

### [Description of the Drawings]

FIG. 1 illustrates a wireless communication system.
FIG. 2 is a diagram for describing a principle of digital pre-distortion (DPD).
FIG. 3 illustrates an example of a transmission circuit including a DPD circuit.
FIG. 4A illustrates an example of a GSM signal obtained through a capture block.
FIG. 4B illustrates an example of a power range of a GSM signal obtained through a capture block.
FIG. 5 illustrates an example of a transmission circuit including a DPD circuit for performing DPD modeling for a signal having a narrow bandwidth.
FIG. 6 is a flowchart for an operation of an electronic device for changing setting information of a DPD circuit.
FIG. 7 illustrates examples of graphs related to samples obtained based on an input signal and an output signal.
FIG. 8 is a flowchart for an operation of an electronic device for identifying a gain value corresponding to each of a plurality of power levels.
FIG. 9A is a flowchart for an operation of an electronic device for performing a first process.
FIG. 9B illustrates a change in gain values within a designated power range according to a first process.
FIG. 10A is a flowchart for an operation of an electronic device for performing a second process.
FIG. 10B illustrates a change in gain values out of a designated power range according to a second process.
FIG. 11A illustrates a change in gain as first gain information is changed to second gain information.
FIG. 11B illustrates a change in phase as first gain information is changed to second gain information.
FIG. 12 illustrates a change in a PA output in a case that setting information of a DPD circuit is changed according to second gain information.
FIG. 13 illustrates a functional configuration of an electronic device including a transmission circuit.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms referring to a signal (e.g., signal, signal flow, composite signal, digital signal, analog signal, modulated signal, distorted signal), terms referring to a resource (e.g., time, symbol, slot, subframe, radio frame, subcarrier, resource element (RE), resource block (RB), bandwidth part (BWP), occasion), terms for a calculation state (e.g., step, operation, procedure), terms referring to data (e.g., packet, user stream, information, bit, symbol, codeword), terms referring to a channel, terms referring to network entities, terms referring to a component of a device, and the like, used in the following description, are exemplified for convenience of description. Accordingly, the present disclosure is not limited to the terms described below, and another term having equivalent technical meanings may be used.

Terms referring to a part of an electronic device (e.g., module, antenna, antenna element, circuit, processor, chip, component, device), terms referring to a circuit (e.g., combining circuit, coupling circuit, separation circuit, distribution circuit, PIMC circuit, harmonic rejection circuit), terms referring to a shape of a part (e.g., structure, structural body, support portion, contact portion, protrusion), terms referring to a circuit (e.g., printed circuit board (PCB), flexible printed circuit board (FPCB), signal line, feeding line, data line, RF signal line, antenna line, RF path, RF module, RF circuit, splitter, divider, coupler, combiner), and the like, used in the following description, are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B).

The present disclosure describes various embodiments using terms used in some communication standards (e.g., 3rd Generation Partnership Project (3GPP), extensible radio access network (xRAN), and open-radio access network (O-RAN)), but this is merely an example for description. Various embodiments of the present disclosure may be easily modified and applied to another communication system.

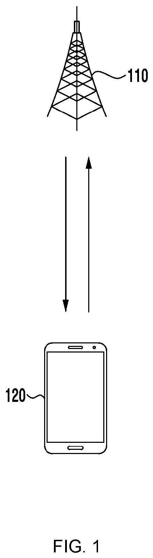

FIG. 1 illustrates a wireless communication system.

Referring to FIG. 1, FIG. 1 illustrates a base station 110 and a terminal 120 as a portion of nodes using a radio channel in the wireless communication system. Although FIG. 1 illustrates only one base station, the wireless communication system may further include another base station identical or similar to the base station 110.

The base station 110 is a network infrastructure that provides wireless access to the terminal 120. The base station 110 has coverage defined based on a distance over which a signal may be transmitted. In addition to a base station, the base station 110 may be referred to as an "access point (AP)," an "eNodeB (eNB)," a "5th generation node," a "next generation nodeB (gNB)," a "wireless point," a "transmission/reception point (TRP)," or another term having a technical meaning equivalent thereto.

The terminal 120, which is a device used by a user, performs communication with the base station 110 through a radio channel. A link directed from the base station 110 to the terminal 120 is referred to as a downlink (DL), and a link directed from the terminal 120 to the base station 110 is referred to as an uplink (UL). In addition, although not illustrated in FIG. 1, the terminal 120 and another terminal may perform communication with each other through a radio channel. In this case, a link (a device-to-device link, D2D) between the terminal 120 and the another terminal is referred to as a sidelink, and the sidelink may be used interchangeably with a PC5 interface. In some other embodiments, the terminal 120 may be operated without involvement of a user. According to an embodiment, the terminal 120, which is a device performing machine type communication (MTC), may not be carried by a user. In addition, according to an embodiment, the terminal 120 may be a narrowband (NB) internet of things (IoT) device.

In addition to a terminal, the terminal 120 may be referred to as "user equipment (UE)," "customer premises equipment (CPE)," a "mobile station," a "subscriber station," a "remote terminal," a "wireless terminal," an "electronic device," a "user device," or another term having a technical meaning equivalent thereto.

According to an embodiment, the base station 110 may emit a signal having high power to transmit a radio signal. The base station 110 may include a power amplifier (hereinafter, PA) for amplifying power of a signal. The PA may be used to amplify power of an input signal. However, as the power of the input signal of the power amplifier (PA) increases, a response of the power amplifier may indicate non-linearity. Finally, the response of the power amplifier may eventually reach a saturation point. Such non-linearity may induce distortion in a transmitted signal and cause degradation of link quality. Accordingly, linearity of the power amplifier is required. Generally, in order to achieve the linearity, it may be required to be input to the power amplifier within a limited power range. Digital pre-distortion may be used to increase a power range of the input signal for the linearity.

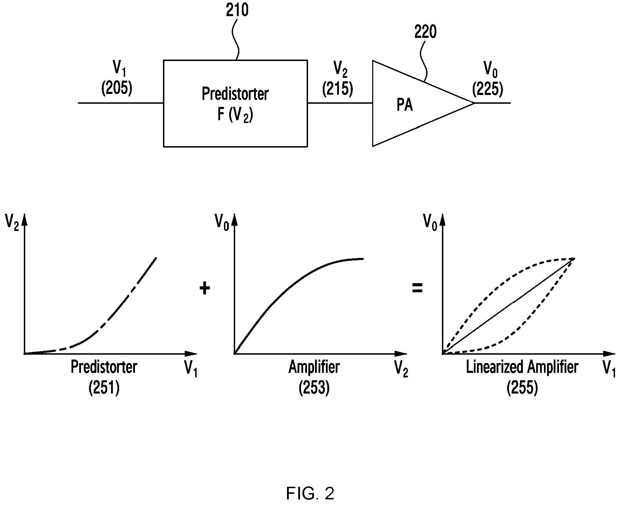

FIG. 2 is a diagram for describing a principle of digital pre-distortion (DPD). Pre-distortion may be performed in a DPD circuit. The DPD circuit may compensate for a distortion component according to a non-linear characteristic of a PA, based on comparison between an input signal and an output signal of the PA. As an input modulated signal distorted through the DPD circuit is input to the PA, a finally modulated signal may be linearly amplified.

Referring to FIG. 2, a DPD circuit 210 may output a DPD output signal 215 based on an input signal 205. The input signal 205 may be pre-distorted into the DPD output signal 215 through the DPD circuit 210. A PA 220 may output an amplifier output signal 225 based on the DPD output signal 215. The DPD output signal 215 may be input to the PA 220. According to a non-linear characteristic of the PA 220, the DPD output signal 215 is distorted. Due to distortion caused by the PA 220, the amplifier output signal 225 is output. Although not illustrated in FIG. 2, analog conversion may be performed on the DPD output signal 215 through a DAC, and up-conversion may be performed on the DPD output signal 215 through a mixer.

A graph 251 represents a relationship between a magnitude of the input signal 205 and a magnitude of the DPD output signal 215. A graph 253 represents a relationship between a magnitude of the DPD output signal 215 and a magnitude of the amplifier output signal 225. A graph 255 represents a relationship between a magnitude of the input signal 205 and a magnitude of the amplifier output signal 225. Referring to the graph 255, through pre-distortion of the DPD circuit 210, an output (e.g., the amplifier output signal 225) with respect to an input (e.g., the input signal 205) may be linear.

The PA 220 may include a transistor. The transistor generates a harmonic component. Due to non-linearity of a low-frequency second harmonic component corresponding to a bandwidth (f2-f1) (f2 is the highest frequency, and f1 is the lowest frequency), a memory effect occurs. As the low-frequency second harmonic component is greater, impedance removal is not easy. Accordingly, the power amplifier exhibits the memory effect as a signal bandwidth increases. In a case that a modulated signal of a wireless communication system is used as a wide bandwidth signal having a wide bandwidth, a distortion component of the power amplifier may include a distortion component not only due to a non-linear characteristic but also due to the memory effect. The memory effect means that a signal non-linearly generated in the past in time affects current non-linearity. That is, the power amplifier is a non-linear system using memory.

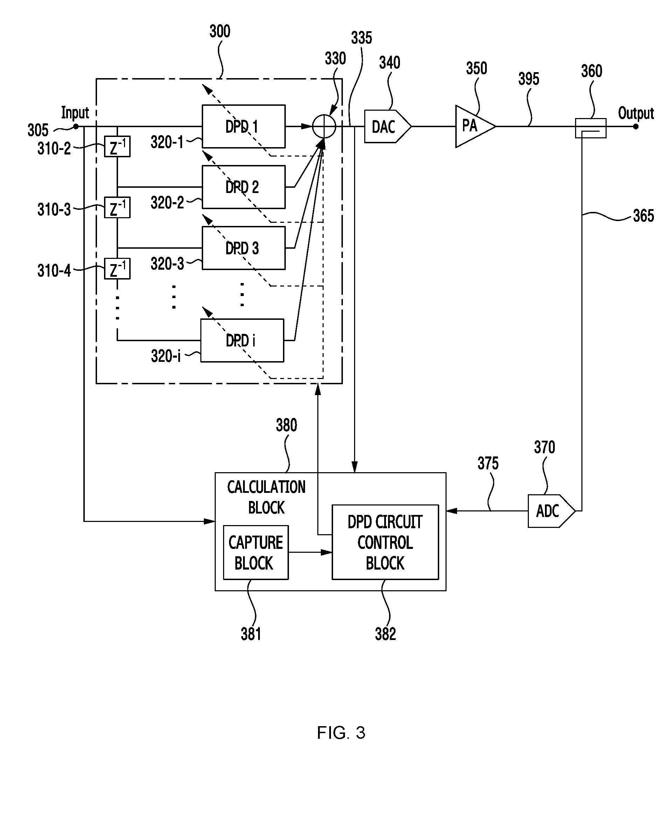

The memory effect may be caused by thermal constants of active devices or components of a biasing network having a frequency-dependent operation. As described above, the distortion component due to the memory effect increases in proportion to a bandwidth of a signal. In order to compensate for both a non-linear distortion component of the power amplifier and a distortion component due to the memory effect, a memory compensated DPD circuit is required. Hereinafter, the memory compensated DPD circuit is described in FIG. 3.

FIG. 3 illustrates an example of a transmission circuit including a DPD circuit. The DPD circuit according to embodiments may compensate for a memory effect. The memory effect means that a signal generated in the past in time affects current non-linearity.

Referring to FIG. 3, a DPD circuit 300 may use a finite impulse response (FIR) filter structure. For implementation of pre-distortion, a polynomial FIR filter may be used. The DPD circuit 300 may include components according to a structure of the FIR filter. The DPD circuit 300 may include a plurality of DPD units, one or more delay elements, and a combiner 330. The plurality of DPD units may include a first DPD unit 320-1, a second DPD unit 320-2, a third DPD unit 320-3, ..., and an i-th DPD unit 320-i. In each DPD unit, a function operation (e.g., multiplication of a coefficient) for a delayed signal may be performed. The i may correspond to a length of the FIR filter. The one or more delay elements may include a second delay element 310-2 connected to the second DPD unit 320-2, a third delay element 310-3 connected to the third DPD unit 320-3, a fourth delay element 310-4 connected to the fourth DPD unit 320-4, ..., and a delay element coupled to an N-th DPD unit. An output of each DPD unit of the plurality of DPD units may be provided to the combiner 330.

The combiner 330 may generate a DPD output signal 335 by combining outputs of the plurality of DPD units. The DPD output signal 335 may be transmitted from the combiner 330 to a DAC 340. According to an embodiment, the DPD output signal 335 may be provided to a calculation block 380. The calculation block 380 means a function performed by a processor.

The DAC 340 may convert the DPD output signal 335 into an analog signal. The DAC 340 may transfer the converted analog signal to a PA 350. Although not illustrated in FIG. 3, up-conversion by a mixer may be performed between the DAC 340 and the PA 350.

The PA 350 may amplify an input signal. A signal 395 amplified by the PA 350 may be transferred to a filter (not illustrated) (e.g., a bandpass filter (BPF)) and an antenna (not illustrated) by passing through a coupler 360. The antenna may radiate a signal. Meanwhile, the PA 350 may include a transistor. The transistor is an active element and intrinsically has a non-linear characteristic. Accordingly, the PA 350 may output a non-linear amplifier output signal with respect to an input signal. The amplifier output signal is linearly proportional to the input signal in a partial region with respect to a magnitude of the input signal. However, in another partial region with respect to the magnitude of the input signal, the PA 350 provides an output not proportional to the input signal. In particular, as a bandwidth of the input signal of the PA 350 is wider, a memory effect due to a second harmonic component of the input signal frequently occurs. A harmonic impedance of an output end of the PA 350 may generate a voltage component. The voltage component may be reflected by a bias line and re-input to the PA 350. Accordingly, the memory effect may occur through interaction between a current input signal and a re-input signal. In order to reduce performance delay due to such the memory effect, the DPD circuit 300 and the calculation block 380 for control of the DPD circuit 300 may be used.

The calculation block 380 may include a capture block 381 and a DPD circuit control block 382.

The capture block 381 may be used to obtain (or capture) an input signal 305, a DPD output signal 335, and an ADC output signal 375. For example, the input signal 305 may be a source signal before being input to the DPD circuit 300. The input signal 305 may be referred to as a DPD input. For example, the DPD output signal 335 may be a signal output from the DPD circuit 300. The DPD output signal 335 may be a signal in which the input signal 305 is distorted according to DPD. The ADC output signal 375 may be a signal into which an output signal of the PA 350 is converted by the ADC 370.

For example, the capture block 381 may obtain (or collect or capture), using at least one of the input signal 305, the DPD output signal 335, and the ADC output signal 375, a certain number (e.g., 8192) of data samples for DPD modeling. The number of data samples to be obtained may be fixed.

The DPD circuit control block 382 may control the DPD circuit 300. For example, the DPD circuit control block 382 may control the DPD circuit 300 for pre-distorting a non-linear characteristic of the PA 350. Operations corresponding to the DPD circuit control block 382 (or the calculation block 380) may be performed by the processor. That is, the processor of the electronic device may generate a control signal for controlling the DPD circuit 300.

According to an embodiment, the processor performing the operations corresponding to the calculation block 380 may determine, based on the bandwidth of the input signal, how much to compensate for the non-linear characteristic of the PA 350 through the DPD circuit 300. As complexity of the DPD circuit 300 becomes higher, a degree of the compensation for the non-linear characteristic of the PA 350 increases. The complexity of the DPD circuit 300 is dependent on the number of activated DPD units. The number of activated DPD units may be referred to as a memory order.

According to an embodiment, the processor performing the operations corresponding to the calculation block 380 may determine control parameters for pre-distorting the non-linear characteristic of the PA 350 by comparing an input signal (e.g., the DPD output signal 335) of the PA 350 and an output signal (e.g., the ADC output signal 375) of the PA 350. Determining the control parameters may be referred to as DPD modeling. For example, DPD modeling may be performed by modeling an inverse function of the PA 350 using data samples obtained through the capture block 380. The DPD modeling may be substantially equivalent to modeling of a system in which the output signal (e.g., the ADC output signal 375) of the PA 350 is set as an input and the input signal (e.g., the DPD output signal 335) of the PA 350 is set as an output.

For example, the processor performing the operations corresponding to the calculation block 380 may obtain an input signal (e.g., the DPD output signal 335) to the DAC 340. The input signal to the DAC 340 may correspond to the input signal of the PA 350. The processor of the calculation block 380 may obtain an output signal of the ADC 370. The output signal of the ADC 370 (or the ADC output signal 375) may correspond to the output signal of the PA 350. A signal 365 isolated through the coupler 360 coupled to the PA 350 may pass through the ADC 370 and be transferred to the calculation block 380.

A result of the DPD modeling may be stored in a form of a look up table (LUT) having a depth of a designated magnitude in the DPD circuit 300. A DPD modeling operation may be repeatedly performed to guarantee DPD performance and correspond to various environments (e.g., temperature and an input signal characteristic).

According to an embodiment, the DPD circuit 300 may be configured based on a long term evolution (LTE) standard and/or a new radio (NR) standard. For example, a bandwidth of a radio signal according to the LTE standard and/or the NR standard may be set from 5 MHz to 20 MHz or more. Accordingly, the calculation block 380 and/or the DPD circuit 300 may be configured to support a signal of a bandwidth of 5 MHz to 20 MHz or more.

The calculation block 380 may fail to identify a characteristic of the PA 350 in a case that a bandwidth of a signal is small compared to a sample rate. For example, even though the certain number (e.g., 8192) of data samples are obtained in the capture block 382, the DPD modeling may not be performed using the calculation block 380. For example, a signal of a global system for mobile communications (GSM) band (e.g., an 850 MHz band, a 900 MHz band, or an 1800 MHz band) may have a bandwidth of 0.2 MHz. A bandwidth of the signal of the GSM band is narrower than the bandwidth of the signal of the LTE standard or the NR standard. Accordingly, the DPD modeling may not be smoothly performed for the signal of the GSM band.

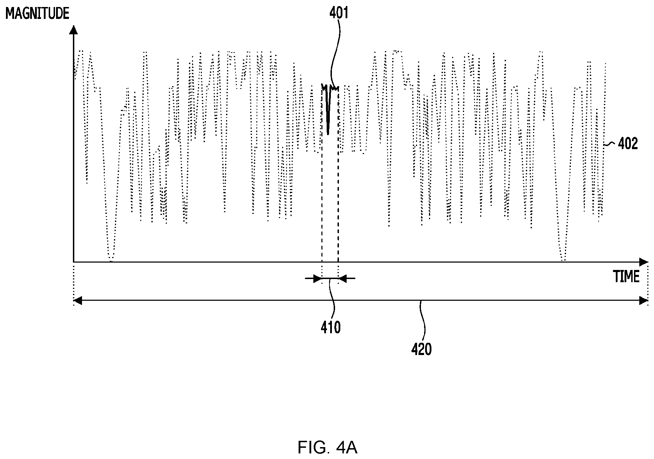

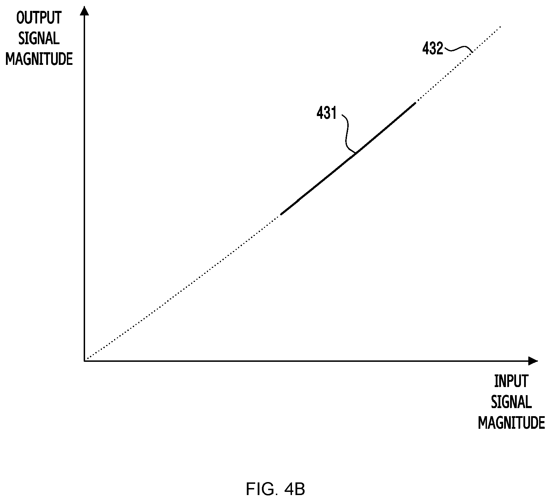

In FIGS. 4A and 4B below, with respect to the signal of the GSM band, an example of a signal (or data samples) obtained in the capture block 381 will be described. Hereinafter, the signal of the GSM band may be referred to as a GSM signal.

FIG. 4A illustrates an example of a GSM signal obtained through a capture block.

FIG. 4B illustrates an example of a power range of a GSM signal obtained through a capture block.

Referring to FIG. 4A, a signal 401 represents a GSM signal obtained (or captured) in a capture block 381 during one sampling interval. A signal 402 represents a GSM signal obtained (or captured) in the capture block 381 according to a plurality of sampling intervals.

For example, in a case that the capture block 381 obtains the GSM signal in the plurality of sampling intervals, the signal 402 similar to the GSM signal may be obtained. However, in a case that the capture block 381 obtains the GSM signal during one sampling interval, the signal 401, which is a portion of the GSM signal, may be obtained. During one sampling interval, only a GSM signal of a time interval 410 among a time interval 420 may be obtained through the capture block 381.

Referring to FIG. 4B, a graph 431 represents a magnitude (or power) of an output signal (e.g., the signal 401 of FIG. 4A) according to a magnitude (or power) of an input signal (e.g., the GSM signal). The graph 431 may be configured based on a signal captured during one sampling interval. The graph 432 represents a magnitude (or power) of an output signal (e.g., the signal 402 of FIG. 4A) according to the magnitude (or the power) of the input signal (e.g., the GSM signal). The graph 432 may be configured based on a signal captured during a plurality of sampling intervals. For example, the output signal may mean a GSM signal obtained through the capture block 381.

According to the graph 431 and the graph 432, in a case that the capture block 381 obtains a GSM signal in the plurality of sampling intervals, a signal similar to the GSM signal may be obtained. However, in a case that the capture block 381 obtains a GSM signal during one sampling interval, only a portion of the GSM signal may be obtained.

Referring to FIGS. 4A and 4B, in a case that a bandwidth of a signal is less than a reference bandwidth, a characteristic of a PA for the signal may not be identified only with data samples obtained in one sampling interval. In addition, since a characteristic of the signal is different for each interval, performance may not be constant in a case that a sampling interval is set differently.

Hereinafter, in the present specification, a technical feature for improving DPD performance for a signal (e.g., a GSM signal) having a narrow bandwidth (e.g., 0.2 MHz) will be described.

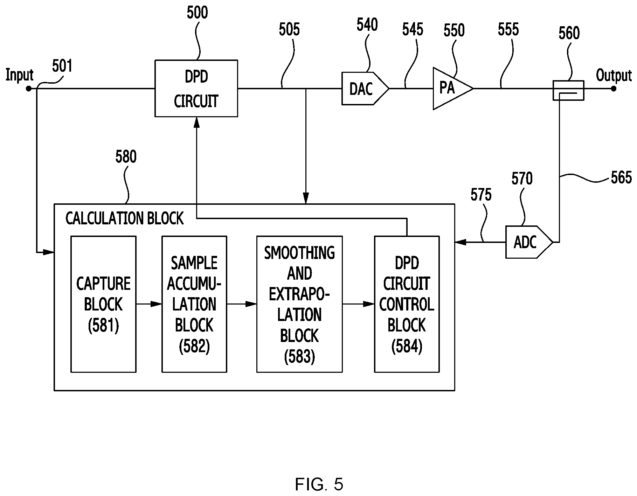

FIG. 5 illustrates an example of a transmission circuit including a DPD circuit for performing DPD modeling for a signal having a narrow bandwidth. The transmission circuit of FIG. 5 may use the transmission circuit of FIG. 3. A calculation block 580 of FIG. 5 may include at least a portion of components (or blocks) of the calculation block 380 of FIG. 3. In addition, terms such as "... unit," "... device," "... object," "... body," and "... block" used below may mean at least one shape structure or a unit for processing a function. The transmission circuit illustrated in FIG. 5 may be included in an electronic device.

Referring to FIG. 5, a DPD circuit 500 may use a finite impulse response (FIR) filter structure. The DPD circuit 500 may include a plurality of DPD units, one or more delay elements, one or more switches, and a combiner (e.g., the combiner 330 of FIG. 3). For example, the DPD circuit 500 may correspond to the DPD circuit 300 of FIG. 3.

A DPD input signal 501 may be input to the DPD circuit 500. The DPD circuit 500 may generate a DPD output signal 505 by combining outputs of the plurality of DPD units. The DPD circuit 500 may output the DPD output signal 505. The DPD output signal 505 may be transmitted to a DAC 540. According to an embodiment, the DPD input signal 501 and the DPD output signal 505 may be provided to a calculation block 580. The calculation block 580 may mean a function performed by a processor of an electronic device including the transmission circuit. Hereinafter, an operation of the calculation block 580 according to embodiments may be understood as a operation of the processor.

The DAC 540 may convert the DPD output signal 505 into an analog signal 545. The DAC 540 may transfer the analog signal 545 to a PA 550. Although not illustrated in FIG. 5, up-conversion by a mixer may be performed between the DAC 540 and the PA 550. The DAC 540 may correspond to the DAC 530 of FIG. 3.

The analog signal 545 may be input to the PA 550. The PA 550 may amplify the input analog signal 545. The PA 550 may convert the analog signal 545 into an amplified signal 555. The amplified signal 555 may be transferred to a filter (not illustrated) (e.g., a bandpass filter (BPF)) and an antenna (not illustrated) by passing through a coupler 560. The antenna may radiate a signal. Meanwhile, the PA 550 may include a transistor. The PA 550 may correspond to the PA 350 of FIG. 3. The coupler 560 may correspond to the coupler 360 of FIG. 3.

An analog signal 565 isolated through the coupler 560 may be input to an ADC 570. The ADC 570 may convert the analog signal 565 into an ADC output signal 575. The ADC output signal 575 may be a digital signal. The ADC output signal 575 may be transferred to the calculation block 580. The ADC output signal 575 may be referred to as a PA output signal. The ADC 570 may correspond to the ADC 370 of FIG. 3.

The calculation block 580 may include a capture block 581, a sample accumulation block 582, a smoothing and extrapolation block 583, and a DPD circuit control block 584.

The capture block 581 may be used to obtain (or capture) the DPD input signal 501, the DPD output signal 505, and the ADC output signal 575. For example, the DPD input signal 501 may be a source signal before being input to the DPD circuit 500. The DPD input signal 501 may be referred to as a DPD input. For example, the DPD output signal 505 may be a signal output from the DPD circuit 500. The DPD output signal 505 may be a signal in which the DPD input signal 501 is distorted according to DPD. The ADC output signal 575 may be a signal into which an output signal of the PA 550 is converted by the ADC 570.

The capture block 581 may obtain (or collect or capture), using at least one of the DPD input signal 501, the DPD output signal 505, and the ADC output signal 575, a designated number of data samples for DPD modeling.

The sample accumulation block 582 may accumulate samples obtained through a plurality of sampling intervals.

The smoothing and extrapolation block 583 may perform a first process to average at least a portion of gain values within a designated power range and/or a second process to estimate gain values out of the designated power range.

The DPD circuit control block 584 may control the DPD circuit 500. For example, the DPD circuit control block 584 may control the DPD circuit 500 for pre-distorting a non-linear characteristic of the PA 550. The DPD circuit control block 584 may be referred to as a DPD adaptation block.

According to an embodiment, operations corresponding to the calculation block 580 may be performed by the processor. For example, the processor of the electronic device may generate a control signal for controlling the DPD circuit 500. For example, the processor of the electronic device may obtain at least one sample using the capture block 581. Hereinafter, in the present specification, for convenience of description, an operation (or calculation) related to the calculation block 580 will be described as being performed by the processor of the electronic device.

According to an embodiment, in order to model an inverse function characteristic of the PA 550, the processor may obtain an output signal (e.g., the ADC output signal 575) related to the PA 550 and an input signal (e.g., the DPD output signal 505) related to the PA 550. The processor may set the output signal related to the PA 550 as an input signal and set the input signal related to the PA 550 as a target signal. The processor may configure a complex gain table using the input signal and the target signal. The complex gain table may be used for a covariance matrix operation of the input signal required for modeling of the inverse function characteristic of the PA 550 and a cross-correlation operation between the input signal and the target signal.

The processor may perform the first process and the second process using the smoothing and extrapolation block 583 so as to perform stable DPD modeling. A specific operation of the first process and the second process will be described below.

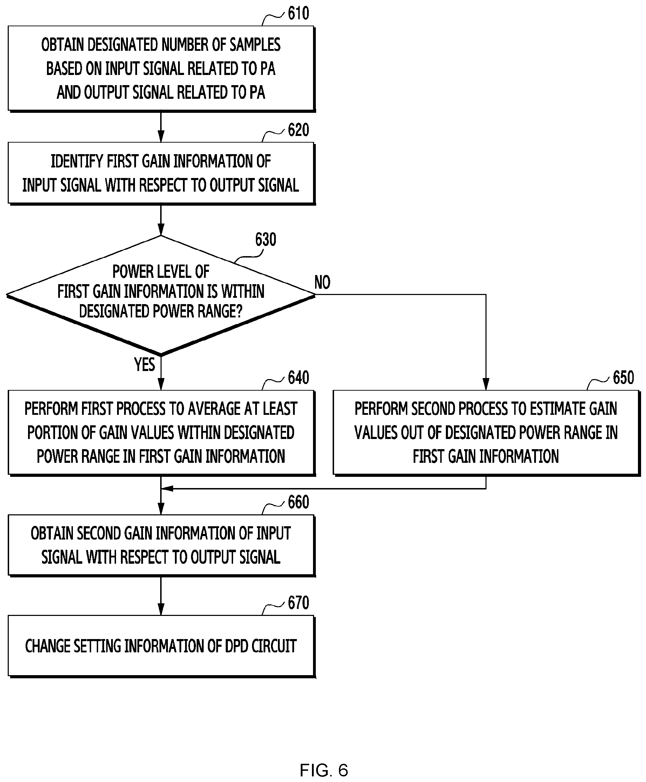

FIG. 6 is a flowchart for an operation of an electronic device for changing setting information of a DPD circuit. Operations described below may be performed by a processor of the electronic device. The processor may perform operation 610 to operation 670 using the calculation block 580 of FIG. 5.

Referring to FIG. 6, in operation 610, the processor may obtain a designated number of samples based on an input signal related to a PA and an output signal related to the PA. For example, the processor may perform a sampling process to obtain at least one sample within a sampling interval. The processor may repeatedly perform the sampling process until the designated number of samples are obtained.

For example, the processor may repeatedly perform the sampling process a designated number of times (e.g., 11 times). The processor may identify that the designated number of samples are obtained based on that the sampling process is repeatedly performed the designated number of times. In a case that the sampling process is performed the designated number of times, the designated number of samples may be obtained. For example, an operation for obtaining the designated number of samples may be referred to as an accumulation process.

In operation 620, the processor may identify first gain information of the input signal with respect to the output signal. For example, the processor may identify the first gain information of the input signal with respect to the output signal based on the designated number of samples.

For example, the processor may identify a reference power range of the output signal. The processor may identify a plurality of power levels corresponding to the reference power range of the output signal. As an example, the number of the plurality of power levels may be set to 256. The plurality of power levels may be configured with integer values greater than or equal to 0 and less than or equal to 255. In the present disclosure, an example in which the plurality of power levels are configured with integer values greater than or equal to 0 and less than or equal to 255 is described, but this is for convenience of description and is not limited thereto. The number and a range of the plurality of power levels may be variously set.

The first gain information may include a gain value with respect to each of the plurality of power levels of the output signal. For example, the processor may identify at least one sampled gain value with respect to each of the plurality of power levels of the output signal. The processor may identify an average value of the at least one sampled gain value as a gain value with respect to each of the plurality of power levels. The processor may identify (or obtain) the first gain information by identifying the gain value with respect to each of the plurality of power levels. An operation of identifying the first gain information may be referred to as a normalize process.

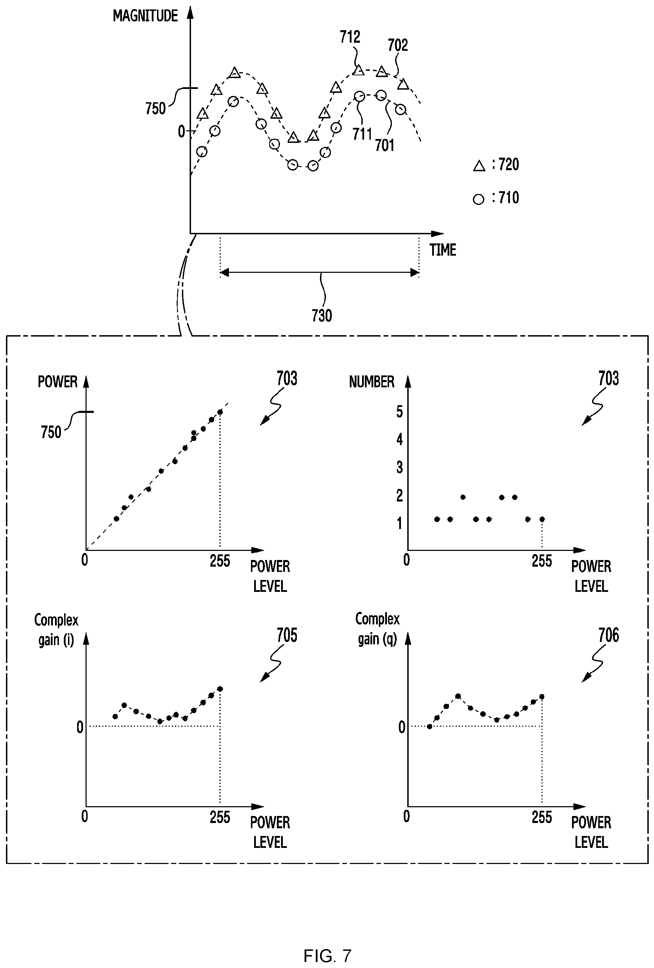

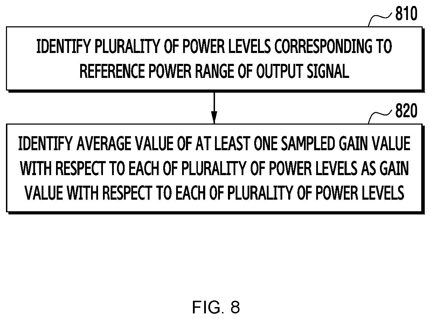

For example, the gain value may be configured as a complex number. The gain value may be referred to as a complex gain value. An example of the at least one sampled gain value with respect to each of the plurality of power levels of the output signal will be described below in FIG. 7. A specific example of an operation of identifying the first gain information will be described below in FIG. 8.

In operation 630, the processor may identify whether a power level of the first gain information is within a designated power range. The processor may identify whether the power level of the first gain information is within the designated power range, in order to perform one of a first process and a second process.

In operation 640, in a case that the power level of the first gain information is within the designated power range, the processor may perform the first process to average at least a portion of gain values within the designated power range in the first gain information. For example, with respect to each of power levels of the output signal, the processor may perform the first process to average the at least a portion of gain values within the designated power range in the first gain information.

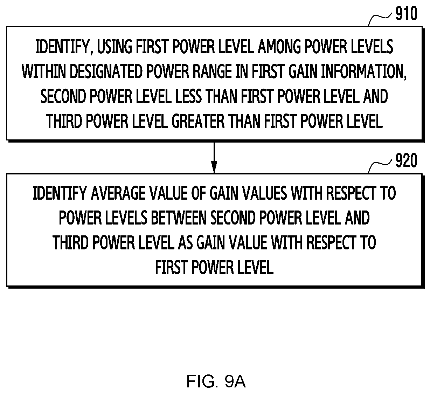

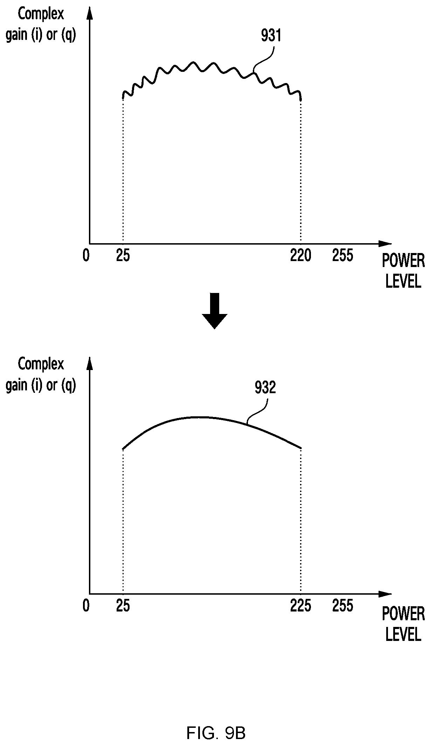

For example, the processor may perform the first process using the smoothing and extrapolation block 583 of FIG. 5. The first process may be referred to as a smoothing process. A specific operation of the first process will be described below in FIGS. 9A and 9B.

In operation 650, in a case that the power level of the first gain information is out of the designated power range, the processor may perform the second process to estimate gain values out of the designated power range in the first gain information. For example, with respect to each of power levels of the output signal, the processor may perform the second process to estimate the gain values out of the designated power range in the first gain information. For example, the processor may estimate the gain values out of the designated power range in the first gain information using an extrapolation.

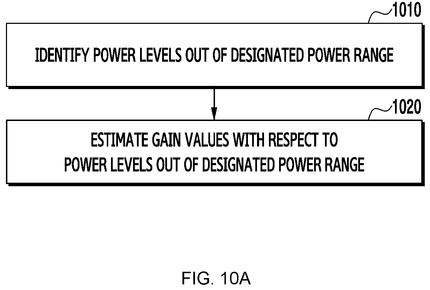

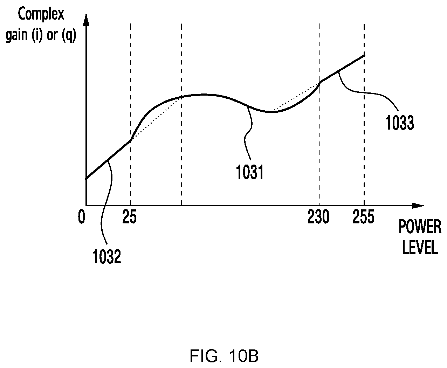

For example, the processor may perform the second process using the smoothing and extrapolation block 583 of FIG. 5. The second process may be referred to as an extrapolation process. A specific operation of the second process will be described below in FIGS. 10A and 10B.

In operation 660, the processor may obtain second gain information of the input signal with respect to the output signal. For example, the processor may obtain the second gain information of the input signal with respect to the output signal based on the first process and the second process. For example, based on that the first gain information is corrected according to the above-described operations, the second gain information may be obtained.

According to an embodiment, the gain value with respect to each of the plurality of power levels, included in the first gain information, may be discontinuously configured. As the first gain information is corrected to the second gain information, the gain value with respect to each of the plurality of power levels may be continuously configured.

In operation 670, the processor may change setting information of the DPD circuit. For example, the processor may change the setting information of the DPD circuit according to the second gain information. The processor may change the setting information of the DPD circuit by changing a control parameter related to the DPD circuit according to the second gain information. For example, the processor may change the setting information of the DPD circuit by storing the second gain information in the DPD circuit. As an example, the second gain information may include a table configured with the gain value with respect to each of the plurality of power levels. The processor may change the setting information of the DPD circuit by storing the table in the DPD circuit. The table may be referred to as a look up table (LUT).

FIG. 7 illustrates examples of graphs related to samples obtained based on an input signal and an output signal.

Referring to FIG. 7, a processor may obtain an input signal (e.g., the DPD output signal 505 of FIG. 5) related to a PA and an output signal (e.g., the ADC output signal 575 of FIG. 5) related to the PA. A graph 701 represents the output signal related to the PA. A graph 702 represents the input signal related to the PA. Although the graph 701 and the graph 702 are displayed to represent a magnitude of a signal according to time for convenience of description, this is for convenience of description, and the graph 701 and the graph 702 may also represent a strength of the signal according to a frequency.

For example, in order to model an inverse function characteristic related to the PA, the processor may set the output signal related to the PA as an input signal of an estimation model. In order to model the inverse function characteristic related to the PA, the processor may set the input signal related to the PA as a target signal.

The processor may obtain (or identify) first gain information of the input signal related to the PA with respect to the output signal related to the PA. The processor may obtain samples to obtain the first gain information. The processor may perform a sampling process to obtain at least one sample within one sampling interval 730.

For example, the processor may obtain at least one sample 710 based on the output signal. The processor may obtain at least one sample 720 based on the input signal. The processor may identify a gain value of the at least one sample 720 with respect to the at least one sample 710. For example, a sample 711 among the at least one sample 710 may correspond to a sample 721 among the at least one sample 720. The processor may configure a signal identified based on the sample 711 and a signal identified based on the sample 721 as in the following equation. [Equation 1] $PA output = a + bi$

Referring to Equation 1, the PA output identified through one sample (e.g., the sample 711) may mean the output signal (e.g., the ADC output signal 575 of FIG. 5) related to the PA. a and b are constants. i is an imaginary unit. [Equation 2] $DPD output = c + di$

Referring to Equation 2, the DPD output identified through one sample (e.g., the sample 721) may mean the input signal (e.g., the DPD output signal 505 of FIG. 5) related to the PA. c and d are constants. i is an imaginary unit.

According to an embodiment, the processor may identify a magnitude of power according to each of the plurality of power levels based on the at least one sample 710. The processor may configure a scatter plot 703 representing the magnitude of power according to each of the plurality of power levels.

For example, the processor may identify a plurality of power levels corresponding to a reference power range of the output signal related to the PA. The processor may set the reference power range for the output signal related to the PA. As an example, the processor may set the maximum value of the plurality of power levels to 255. The processor may set the minimum value of the plurality of power levels to 0. For example, the processor may perform quantization on a magnitude of power of the output signal related to the PA and identify it as one of power levels from 0 to 255. In FIG. 7, an example in which the plurality of power levels are set to 256 is illustrated, but the disclosure is not limited thereto. The number of the plurality of power levels may be variously set. For example, the power level 255 may correspond to a power value 750. According to an embodiment, the power level 255 may correspond to the maximum power value of the output signal related to the PA.

For example, the magnitude of the power of the output signal related to the PA according to a power level may be configured as in the following equation. [Equation 3] $pwr \left[n\right] = {a}^{2} + {b}^{2} , 0 \leq n \leq N$

In Equation 3, n is a power level. n is set to one of levels greater than or equal to 0 and less than or equal to N. N is a power level corresponding to the maximum power of the output signal related to the PA. pwr[n] is a magnitude of power of the output signal for the power level n. n is a power level into which a power value of the output signal related to the PA is quantized into N steps. In FIG. 7, an example in which N is set to 255 is illustrated, but it is not limited thereto. The scatter plot 703 for the at least one sample 710 may be configured according to Equation 3.

According to an embodiment, the processor may configure a scatter plot 704 representing the number for each of the plurality of power levels identified using the at least one sample 710.

According to an embodiment, the processor may configure a scatter plot 705 and a scatter plot 706 representing a gain of the input signal with respect to the output signal using the at least one sample 710 and the at least one sample 720. The scatter plot 705 may represent a real-part gain values of the input signal with respect to the output signal. The scatter plot 706 may represent imaginary-part gain values of the input signal with respect to the output signal.

For example, a complex gain value of the input signal with respect to the output signal may be configured as in the following equation. [Equation 4] $complex gain \left[n\right] = \frac{c + di}{a + bi} = \frac{ac + bd}{pwr} + \frac{ad - bc}{pwr} i , 0 \leq n \leq N$

Referring to Equation 4, complex gain[n] is a complex gain value of the input signal with respect to the output signal. pwr is configured as in Equation 3. [Equation 5] $complex gain \left[n\right] \left(i\right) = \frac{ac + bd}{pwr}$ [Equation 6] $complex gain \left[n\right] \left(q\right) = \frac{ad - bc}{pwr}$

Referring to Equations 5 and 6, complex gain[n](i) represents real-part gain values of the input signal with respect to the output signal. complex gain[n](q) represents imaginary-part gain values of the input signal with respect to the output signal.

The scatter plot 705 and the scatter plot 706 for the at least one sample 710 may be configured according to Equations 5 and 6.

According to an embodiment, the processor may repeatedly perform the above-described sampling process. The processor may repeatedly perform the sampling process until a designated number of samples are obtained. Thereafter, the processor may identify (or obtain) the first gain information by identifying a gain value corresponding to each of the plurality of power levels. In order to identify the first gain information, an operation of identifying the gain value corresponding to each of the plurality of power levels will be described below in FIG. 8.

FIG. 8 is a flowchart for an operation of an electronic device for identifying a gain value corresponding to each of a plurality of power levels.

Referring to FIG. 8, in operation 810, a processor may identify a plurality of power levels corresponding to a reference power range of an output signal related to a PA. For example, the processor may set the reference power range. For example, the maximum value of the reference power range may be set to the maximum value of the output signal related to the PA. The minimum value of the reference power range may be set to 0. As an example, the processor may set the maximum value of the plurality of power levels to 255. The processor may set the minimum value of the plurality of power levels to 0. For example, the processor may perform quantization on a magnitude of power of the output signal related to the PA and identify it as one of power levels from 0 to 255.

In operation 820, the processor may identify an average value of at least one sampled gain value with respect to each of the plurality of power levels as a gain value with respect to each of the plurality of power levels. For example, the at least one sampled gain value may be identified using a designated number of samples.

According to an embodiment, the processor may identify the average value of the at least one sampled gain value (e.g., a complex gain value) with respect to each of the plurality of power levels based on the designated number of samples. The processor may identify the average value of the at least one sampled gain value (e.g., the complex gain value) with respect to each of the plurality of power levels as the gain value with respect to each of the plurality of power levels.

For example, the processor may identify an average value of at least one sampled real-part gain value with respect to each of the plurality of power levels as a real-part gain value with respect to each of the plurality of power levels. The processor may identify an average value of at least one sampled imaginary-part gain value with respect to each of the plurality of power levels as an imaginary-part gain value with respect to each of the plurality of power levels.

For example, at least one sampled gain value may be obtained with respect to one power level. The processor may identify an average value of the at least one sampled gain value, in order to identify one gain value with respect to the one power level. The processor may identify the identified average value as a gain value with respect to the one power level. The processor may identify a gain value corresponding to each of the plurality of power levels by performing the same operation with respect to each of the plurality of power levels. An operation of identifying the gain value corresponding to each of the plurality of power levels may be referred to as a normalization process.

FIG. 9A is a flowchart for an operation of an electronic device for performing a first process.

FIG. 9B illustrates a change in gain values within a designated power range according to a first process.

Referring to FIG. 9A, in operation 910, a processor may identify, using a first power level among power levels within a designated power range in first gain information, a second power level less than the first power level and a third power level greater than the first power level.

According to an embodiment, the processor may determine the designated power range. The processor may identify the power levels within the designated power range. For example, the processor may set a portion of a plurality of power levels as the designated power range. As an example, in a case that the plurality of power levels are configured from 0 to 255, the designated power range may be set to a range greater than 25 and less than or equal to 220.

According to an embodiment, the processor may identify, with the first power level among the power levels within the designated power range as a center, the second power level less than the first power level and the third power level greater than the first power level.

For example, the processor may identify the second power level less than the first power level. The processor may identify the third power level greater than the first power level. The processor may identify the second power level less than the first power level by a designated level. The processor may identify the third power level greater than the first power level by the designated level. The processor may determine the designated power range based on the designated level. As an example, in a case that the first power level is 100, the processor may identify the second power level as 75 and identify the third power level as 125.

In operation 920, the processor may identify an average value of gain values with respect to power levels between the second power level and the third power level as a gain value with respect to the first power level.

For example, the processor may identify power levels between the second power level and the third power level. The processor may identify a gain value with respect to each of the identified power levels. The processor may identify an average value of gain values with respect to the identified power levels. The processor may identify the identified average value as a gain value with respect to the first power level.

For example, in a case that the first power level is 100, the processor may identify the second power level as 75 and identify the third power level as 125. The processor may identify gain values from a power level 75 to a power level 125. The processor may set an average value of the identified gain values as a gain value of the first power level.

For example, an operation of identifying an average value of gain values with respect to power levels between the second power level and the third power level as a gain value with respect to the first power level may be performed based on the following equation. [Equation 7] $complex _ gain \left[n\right] = {\sum }_{m = \left(n-25\right)}^{n + 25} complex _ gain \left[m\right] / 51$

Referring to Equation 7, n may be performed within a range greater than 25 and less than or equal to N-25. In other words, the designated power range may be a range greater than 25 and less than or equal to N-25. n is the first power level. (n-25) is the second power level. (n+25) is the third power level.

According to an embodiment, the processor may perform the above-described operation with respect to each of power levels within the designated power range. The processor may perform the first process based on performing the above-described operation with respect to each of the power levels within the designated power range. An example of changes in gain values with respect to the power levels within the designated power range according to the first process will be described in FIG. 9B.

Referring to FIG. 9B, the designated power range may be set to a range greater than 25 and less than or equal to 220. The processor may perform the first process by performing the above-described operation with respect to each of power levels within the designated power range. Before the first process is performed, a gain value according to the power levels within the designated power range may be configured as a graph 931. After the first process is performed, a gain value according to the power levels within the designated power range may be configured as a graph 932.

According to an embodiment, the processor may smoothly change a change in a gain value according to the power levels within the designated power range by performing the first process (or the smoothing process) using the smoothing and extrapolation block 583 of FIG. 5.

FIG. 10A is a flowchart for an operation of an electronic device for performing a second process.

FIG. 10B illustrates a change in gain values out of a designated power range according to a second process.

Referring to FIG. 10A, in operation 1010, a processor may identify power levels out of a designated power range.

According to an embodiment, the processor may determine the designated power range. The processor may identify power levels out of the designated power range. For example, the processor may set a portion of a plurality of power levels as the designated power range. As an example, in a case that the plurality of power levels are configured from 0 to 255, the designated power range may be set to a range greater than 25 and less than or equal to 220. The power levels out of the designated power range may include power levels from 0 to 25 and power levels from 221 to 225.

In operation 1020, the processor may estimate gain values with respect to the power levels out of the designated power range. For example, the processor may estimate the gain values with respect to the power levels out of the designated power range by performing an extrapolation using first gain information.

For example, as an example, in a case that the plurality of power levels are configured from 0 to 255, the power levels out of the designated power range may include power levels from 0 to 25 and power levels from 221 to 225. The extrapolation may be performed on gain values (e.g., complex gain values) of the power levels from 0 to 25 according to the following Equation 8. The extrapolation may be performed on gain values (e.g., complex gain values) of the power levels from 221 to 225 according to the following Equation 9. The processor may estimate a gain value with respect to each of the power levels out of the designated power range by performing the extrapolation. [Equation 8] $complex _ gain \left[n\right] = \left(\frac{complex _ gain \left[25+Extrapolation_size\right] - complex _ gain \left[25\right]}{\left(Extrapolation_size\right)}\right) ∗ n , \left(0\leq n\leq 25\right)$ [Equation 9] $complex _ gain \left[n\right] = \left(\frac{complex _ gain \left[N-25\right] - complex _ gain \left[N-25-Extrapolation_size\right]}{\left(Extrapolation_size\right)}\right) ∗ n , \left(N-25<n\leq N\right)$

Referring to Equations 8 and 9, Extrapolation_size is a value for determining a slope for the extrapolation. For example, Extrapolation_size may be set to 12.

According to an embodiment, the processor may perform the above-described operation with respect to each of the power levels out of the designated power range. The processor may perform the second process based on performing the above-described operation with respect to each of the power levels out of the designated power range. An example in which gain values with respect to the power levels out of the designated power range are estimated according to the second process will be described in FIG. 10B.

Referring to FIG. 10B, the designated power range may be set to a range greater than 25 and less than or equal to 220. The power levels out of the designated power range may include power levels from 0 to 25 and power levels from 221 to 225.

The processor may perform the second process by performing the above-described operation with respect to each of the power levels out of the designated power range. Before the second process is performed, a gain value according to the power levels within the designated power range may be configured as a graph 1031. After the second process is performed, estimated gain values according to the power levels out of the designated power range may be configured as a graph 1032 and a graph 1033.

According to an embodiment, the processor may estimate a gain value according to the power levels out of the designated power range by performing the second process (or the extrapolation process) using the smoothing and extrapolation block 583 of FIG. 5.

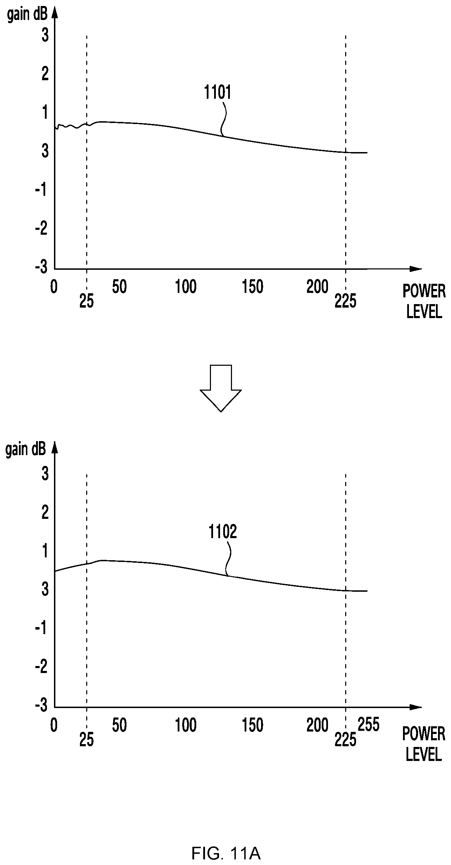

FIG. 11A illustrates a change in gain as first gain information is changed to second gain information.

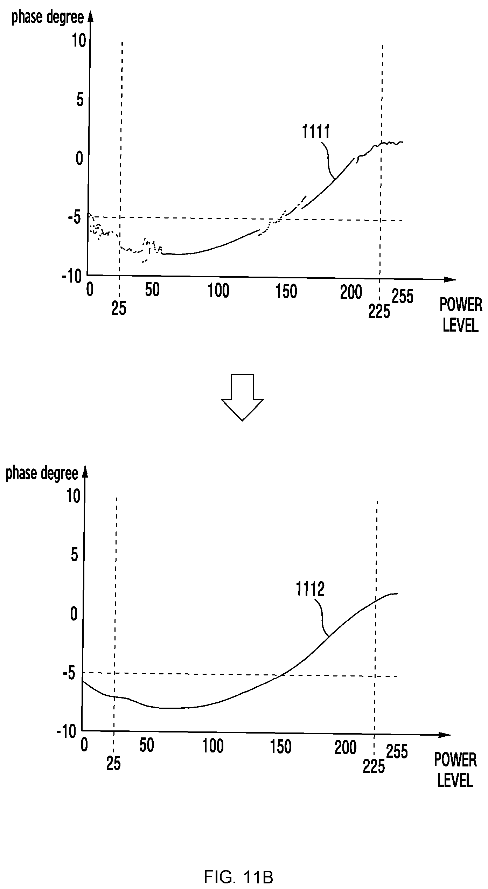

FIG. 11B illustrates a change in phase as first gain information is changed to second gain information.

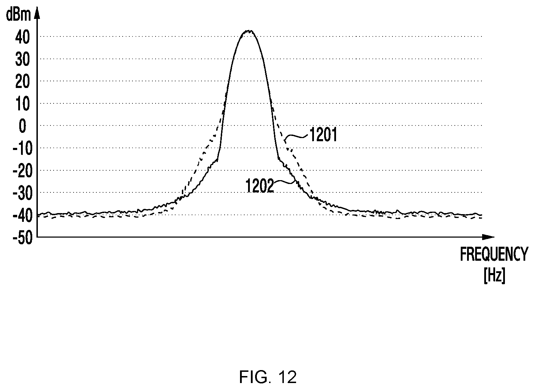

FIG. 12 illustrates a change in a PA output in a case that setting information of a DPD circuit is changed according to second gain information.

Referring to FIGS. 11A and 11B, a graph 1101 and a graph 1102 represent a change in gain according to a power level. A graph 1111 and a graph 1112 represent a change in phase according to the power level. The graph 1101 and the graph 1111 may be configured based on the first gain information. The graph 1102 and the graph 1112 may be configured based on the second gain information. The graph 1101 and the graph 1111 may be discontinuous or may not be smoothly configured in a signal having a narrow bandwidth. The graph 1101 and the graph 1111 may not be suitable for modeling an inverse function characteristic of the PA. The processor may identify the second gain information using the first gain information. The graph 1102 and the graph 1112 configured based on the second gain information may be continuous and smoothly configured even in a signal having a narrow bandwidth. The graph 1102 and the graph 1112 may be suitable for modeling the inverse function characteristic of the PA.

Referring to FIG. 12, the graph 1201 and the graph 1202 represent a PA output according to frequency. The graph 1201 represents the PA output according to frequency in a case that the transmission circuit illustrated in FIG. 3 is applied. The graph 1202 represents the PA output according to frequency in a case that the transmission circuit illustrated in FIG. 5 is applied. As the transmission circuit illustrated in FIG. 5 is applied, performance with respect to the PA output is further improved.

According to the above-described embodiment, DPD modeling may be performed at once even for a signal having a narrow bandwidth by accumulating many samples. In addition, discontinuously configured signals may be continuously configured and smoothly configured through a first process (or a smoothing process) and a second process (or an extrapolation process).

According to the above-described embodiment, a signal may be captured in various time intervals not only for a specific interval of a power level of the signal but also for all power levels of the signal. The DPD modeling may be smoothly performed even for a signal having a narrow bandwidth. Therefore, DPD performance may be improved.

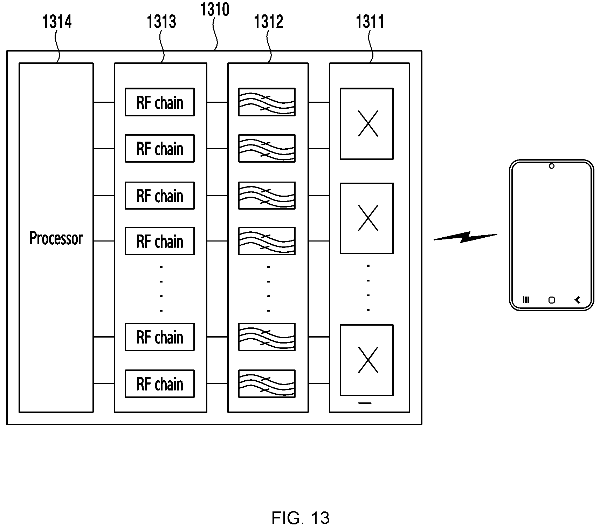

FIG. 13 illustrates a functional configuration of an electronic device including a transmission circuit.

An electronic device 1310 may be the base station 110 of FIG. 1 or an MMU of the base station 110. Meanwhile, unlike the illustration, the present disclosure does not exclude that the electronic device 1310 may also be implemented in the terminal 120 of FIG. 1. Through FIGS. 1 to 12, not only a communication module related to a transmission circuit but also an electronic device including the same is included in embodiments of the present disclosure.

Referring to FIG. 13, an exemplary functional configuration of the electronic device 1310 is illustrated. The electronic device 1310 may include an antenna unit 1311, a filter unit 1312, a radio frequency (RF) processing unit 1313, and a processor 1314.

The antenna unit 1311 may include one or more antennas. An antenna performs functions for transmitting and receiving a signal through a wireless channel. The antenna may include a radiator formed of a conductive body or a conductive pattern formed on a substrate (e.g., a PCB). The antenna may radiate an up-converted signal on the wireless channel or obtain a signal radiated by another device. Each antenna may be referred to as an antenna element or an antenna device. In some embodiments, the antenna unit 1311 may include an antenna array in which a plurality of antenna elements form an array. The antenna unit 1311 may be electrically connected to the filter unit 1312 through RF signal lines. The antenna unit 1311 may be mounted on a PCB including the plurality of antenna elements. The PCB may include a plurality of RF signal lines connecting each antenna element and a filter of the filter unit 1312. These RF signal lines may be referred to as a feeding network.

The antenna unit 1311 may provide a received signal to the filter unit 1312 or radiate a signal provided from the filter unit 1312 into the air. The filter unit 1312 may perform filtering in order to transfer a signal of a desired frequency. The filter unit 1312 may perform a function for selectively identifying a frequency by forming a resonance. The filter unit 1312 may include at least one of a band pass filter, a low pass filter, a high pass filter, or a band reject filter. That is, the filter unit 1312 may include RF circuits for obtaining a signal of a frequency band for transmission or a signal of a frequency band for reception. The filter unit 1312 according to embodiments may electrically connect the antenna unit 1311 and the RF processing unit 1313.

The RF processing unit 1313 may include a plurality of RF paths. An RF path may be a unit of a path through which a signal received through an antenna or a signal radiated through an antenna passes. At least one RF path may be referred to as an RF chain. The RF chain may include a plurality of RF elements. The RF elements may include an amplifier, a mixer, an oscillator, a DAC, an ADC, and the like. For example, the RF processing unit 1313 may include a mixer for up-converting a transmission signal to a transmission frequency. A transmission path of the RF processing unit 1313 may include a DAC, a mixer, an oscillator, and an amplifier. A reception path of the RF processing unit 1313 may include an ADC, a mixer, an oscillator, and an LNA. The transmission path may further include a coupler (or a combiner). Also, for example, the RF processing unit 1313 may include a mixer for down-converting an analog RF reception signal to a digital frequency. The reception path of the RF processing unit 1313 may include a low-noise amplifier (LNA), a mixer, an oscillator, and an ADC. The reception path may further include a coupler or an attenuator.

RF components of the RF processing unit may be implemented on a PCB. The electronic device 1310 may include a structure stacked in an order of the antenna unit 1311, the filter unit 1312, and the RF processing unit 1313. Antennas and the RF components of the RF processing unit may be implemented on a PCB, and filters may form a plurality of layers by being repeatedly fastened between a PCB and a PCB.

The processor 1314 may control overall operations of the electronic device 1310. The processor 1314 may include various modules for performing communication. Although one processor is illustrated in FIG. 13, the processor 1314 may also include a plurality of processors. The processor 1314 may include modules for digital signal processing. For example, the processor 1314 may include a component (e.g., a baseband modem) for controlling a DPD circuit. For another example, the processor 1314 may include a component (e.g., a chip) for operating the DPD circuit. When transmitting data, the processor 1314 generates complex symbols by encoding and modulating a transmission bitstream. In addition, for example, when receiving data, the processor 1314 restores a reception bitstream through demodulation and decoding of a baseband signal. The processor 1314 may perform functions of a protocol stack required by a communication standard.

In FIG. 13, a functional configuration of the electronic device 1310 has been described as equipment in which the antenna structure of the present disclosure may be utilized. However, the example illustrated in FIG. 13 is merely an exemplary configuration for utilization of the antenna structure according to embodiments of the present disclosure described through FIGS. 1 to 12, and the embodiments of the present disclosure are not limited to components of the equipment illustrated in FIG. 13. Therefore, an antenna module including the antenna structure, communication equipment having another configuration, and the antenna structure itself may also be understood as embodiments of the present disclosure.

According to an embodiment, an electronic device may comprise a digital pre-distortion (DPD) circuit, a digital-to-analog converter (DAC) coupled to the DPD circuit, a power amplifier (PA) coupled to the DAC, an analog-to-digital converter (ADC) coupled to the PA, at least one processor comprising processing circuitry, and memory, comprising one or more storage mediums, storing instructions. The instructions, when executed by the at least one processor individually or collectively, may cause the electronic device to obtain, based on an input signal related to the PA and an output signal related to the PA, a designated number of samples. The instructions, when executed by the at least one processor individually or collectively, may cause the electronic device to, based on the designated number of samples, identify first gain information of the input signal with respect to the output signal. The instructions, when executed by the at least one processor individually or collectively, may cause the electronic device to, with respect to each of power levels of the output signal, perform a first process to average at least a portion of gain values within a designated power range in the first gain information. The instructions, when executed by the at least one processor individually or collectively, may cause the electronic device to, with respect to each of power levels of the output signal, perform a second process to estimate gain values out of the designated power range in the first gain information. The instructions, when executed by the at least one processor individually or collectively, may cause the electronic device to, based on the first process and the second process, obtain second gain information of the input signal with respect to the output signal. The instructions, when executed by the at least one processor individually or collectively, may cause the electronic device to change setting information of the DPD circuit according to the second gain information.

According to an embodiment, the instructions, when executed by the at least one processor individually or collectively, may cause the electronic device to perform a sampling process to obtain at least one sample within a sampling interval. The instructions, when executed by the at least one processor individually or collectively, may cause the electronic device to perform the sampling process repeatedly until the designated number of samples are obtained.

According to an embodiment, the instructions, when executed by the at least one processor individually or collectively, may cause the electronic device to identify a plurality of power levels corresponding to a reference power range of the output signal. The instructions, when executed by the at least one processor individually or collectively, may cause the electronic device to identify an average value of at least one sampled gain value for each of the plurality of power levels as a gain value for each of the plurality of power levels. The at least one sampled gain value may be identified using the designated number of samples.

According to an embodiment, the instructions, when executed by the at least one processor individually or collectively, may cause the electronic device to identify, using a first power level among power levels within the designated power range, a second power level less than the first power level and a third power level greater than the first power level. The instructions, when executed by the at least one processor individually or collectively, may cause the electronic device to identify gain values for the power levels within the designated power range by identifying an average value of gain values for power levels between the second power level and the third power level as a gain value for the first power level. The instructions, when executed by the at least one processor individually or collectively, may cause the electronic device to, based on identifying the gain values for the power levels within the designated power range, perform the first process.

According to an embodiment, the instructions, when executed by the at least one processor individually or collectively, may cause the electronic device to identify power levels out of the designated power range. The instructions, when executed by the at least one processor individually or collectively, may cause the electronic device to estimate the gain values for the power levels out of the designated power range by performing an extrapolation using the first gain information. The instructions, when executed by the at least one processor individually or collectively, may cause the electronic device to, based on estimating the gain values for the power levels out of the designated power range, perform the second process.

According to an embodiment, the output signal may be configured for a radio signal transmitted through a global system for mobile communications (GSM) band.

According to an embodiment, the radio signal may have a bandwidth of 0.2 MHz.

According to an embodiment, the input signal related to the PA may comprise a signal input to the PA through the DAC. The output signal related to the PA may comprise a signal output from the PA through the ADC.

According to an embodiment, the instructions, when executed by the at least one processor individually or collectively, may cause the electronic device to store the second gain information to the DPD circuit.

According to an embodiment, the second gain information may comprise a table configured with a gain value for each of the plurality of power levels.

According to an embodiment, a method performed by an electronic device may comprise obtaining, based on an input signal related to a power amplifier (PA) of the electronic device and an output signal related to the PA, a designated number of samples. The method may comprise, based on the designated number of samples, identifying first gain information of the input signal with respect to the output signal. The method may comprise, with respect to each of power levels of the output signal, performing a first process to average at least a portion of gain values within a designated power range in the first gain information. The method may comprise, with respect to each of power levels of the output signal, performing a second process to estimate gain values out of the designated power range in the first gain information. The method may comprise, based on the first process and the second process, obtaining second gain information of the input signal with respect to the output signal. The method may comprise changing setting information of a digital pre-distortion (DPD) circuit of the electronic device according to the second gain information.

According to an embodiment, the method may comprise performing a sampling process to obtain at least one sample within a sampling interval. The method may comprise performing the sampling process repeatedly until the designated number of samples are obtained.

According to an embodiment, the method may comprise identifying a plurality of power levels corresponding to a reference power range of the output signal. The method may comprise identifying an average value of at least one sampled gain value for each of the plurality of power levels as a gain value for each of the plurality of power levels. The at least one sampled gain value may be identified using the designated number of samples.

According to an embodiment, the method may comprise identifying, using a first power level among power levels within the designated power range, a second power level less than the first power level and a third power level greater than the first power level. The method may comprise identifying gain values for the power levels within the designated power range by identifying an average value of gain values for power levels between the second power level and the third power level as a gain value for the first power level. The method may comprise, based on identifying the gain values for the power levels within the designated power range, performing the first process.

According to an embodiment, the method may comprise identifying power levels out of the designated power range. The method may comprise estimating the gain values for the power levels out of the designated power range by performing an extrapolation using the first gain information. The method may comprise, based on estimating the gain values for the power levels out of the designated power range, performing the second process.

According to an embodiment, the output signal may be configured for a radio signal transmitted through a global system for mobile communications (GSM) band.

According to an embodiment, the radio signal may have 0.2 MHz bandwidth.

According to an embodiment, the input signal related to the PA may comprise a signal input to the PA through the DAC. The output signal related to the PA may comprise a signal output from the PA through the ADC.

According to an embodiment, the method may comprise storing the second gain information to the DPD circuit.

According to an embodiment, an electronic device may comprise a digital pre-distortion (DPD) circuit, a digital-to-analog converter (DAC) coupled to the DPD circuit, a power amplifier (PA) coupled to the DAC, an analog-to-digital converter (ADC) coupled to the PA, and at least one processor. The at least one processor may be configured to obtain, based on an input signal related to the PA and an output signal related to the PA, a designated number of samples. The at least one processor may be configured to, based on the designated number of samples, identify first gain information of the input signal with respect to the output signal. The at least one processor may be configured to, with respect to each of power levels of the output signal, perform a first process to average at least part of gain values within a designated power range in the first gain information. The at least one processor may be configured to, with respect to each of power levels of the output signal, perform a second process to estimate gain values out of the designated power range in the first gain information. The at least one processor may be configured to, based on the first process and the second process, obtain second gain information of the input signal with respect to the output signal. The at least one processor may be configured to change setting information of the DPD circuit according to the second gain information.

According to an embodiment, a non-transitory computer readable storage medium may store one or more programs. The one or more programs may comprise instructions, which, when executed by a processor of an electronic device with a digital pre-distortion (DPD) circuit, a digital-to-analog converter (DAC) coupled to the DPD circuit, a power amplifier (PA) coupled to the DAC, and an analog-to-digital converter (ADC) coupled to the PA, cause the electronic device to obtain, based on an input signal related to the PA and an output signal related to the PA, a designated number of samples. The one or more programs may comprise instructions, which, when executed by the processor of the electronic device, cause the electronic device to, based on the designated number of samples, identify first gain information of the input signal with respect to the output signal. The one or more programs may comprise instructions, which, when executed by the processor of the electronic device, cause the electronic device to, with respect to each of power levels of the output signal, perform a first process to average at least a portion of gain values within a designated power range in the first gain information. The one or more programs may comprise instructions, which, when executed by the processor of the electronic device, cause the electronic device to, with respect to each of power levels of the output signal, perform a second process to estimate gain values out of the designated power range in the first gain information. The one or more programs may comprise instructions, which, when executed by the processor of the electronic device, cause the electronic device to, based on the first process and the second process, obtain second gain information of the input signal with respect to the output signal. The one or more programs may comprise instructions, which, when executed by the processor of the electronic device, cause the electronic device to change setting information of the DPD circuit according to the second gain information.

According to the above-described embodiment, in a wireless communication system, DPD performance for stably compensating for non-linearity of a PA may be improved. In a case that an existing general data capture scheme is used, DPD performance degradation occurs in a signal having a narrow bandwidth. According to the above-described embodiment, DPD modeling may be stably performed even in a narrow communication band such as a GSM band. According to the above-described embodiment, DPD modeling and/or amplifier (AMP) performance may be improved for all signals regardless of a magnitude of bandwidth.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

Meanwhile, specific embodiments have been described in the detailed description of the present disclosure, and of course, various modifications are possible without departing from the scope of the present disclosure.

## Claims

1. An electronic device comprising:
a digital pre-distortion (DPD) circuit;
a digital-to-analog converter (DAC) coupled to the DPD circuit;
a power amplifier (PA) coupled to the DAC;
an analog-to-digital converter (ADC) coupled to the PA;
at least one processor comprising processing circuitry; and
memory, comprising one or more storage mediums, storing instructions,
wherein the instructions, when executed by the at least one processor individually or collectively, cause the electronic device to:
obtain, based on an input signal related to the PA and an output signal related to the PA, a designated number of samples,
based on the designated number of samples, identify first gain information of the input signal with respect to the output signal,
with respect to each of power levels of the output signal, perform a first process to average at least a portion of gain values within a designated power range in the first gain information,
with respect to each of the power levels, perform a second process to estimate gain values out of the designated power range in the first gain information,
based on the first process and the second process, obtain second gain information of the input signal with respect to the output signal, and
change setting information of the DPD circuit according to the second gain information.

2. The electronic device of claim 1, wherein the instructions, when executed by the at least one processor individually or collectively, further cause the electronic device to:
perform a sampling process to obtain at least one sample within a sampling interval, and
perform the sampling process repeatedly until the designated number of samples are obtained.

3. The electronic device of claim 1, wherein the instructions, when executed by the at least one processor individually or collectively, further cause the electronic device to:
identify a plurality of power levels corresponding to a reference power range of the output signal, and
identify an average value of at least one sampled gain value for each of the plurality of power levels as a gain value for each of the plurality of power levels, and
wherein the at least one sampled gain value is identified using the designated number of samples.

4. The electronic device of claim 1, wherein the instructions, when executed by the at least one processor individually or collectively, further cause the electronic device to:
identify, using a first power level among power levels within the designated power range, a second power level less than the first power level and a third power level greater than the first power level,
identify gain values for the power levels within the designated power range by identifying an average value of gain values for power levels between the second power level and the third power level as a gain value for the first power level, and
based on identifying the gain values for the power levels within the designated power range, perform the first process.

5. The electronic device of claim 1, wherein the instructions, when executed by the at least one processor individually or collectively, further cause the electronic device to:
identify power levels out of the designated power range,
estimate the gain values for the power levels out of the designated power range by performing an extrapolation using the first gain information, and
based on estimating the gain values for the power levels out of the designated power range, perform the second process.

6. The electronic device of claim 1, wherein the output signal is configured for a radio signal transmitted through a global system for mobile communications (GSM) band.

7. The electronic device of claim 6, wherein the radio signal has a bandwidth of 0.2 MHz.

8. The electronic device of claim 1, wherein the input signal related to the PA comprises a signal input to the PA through the DAC, and
wherein the output signal related to the PA comprises a signal output from the PA through the ADC.

9. The electronic device of claim 1, wherein the instructions, when executed by the at least one processor individually or collectively, further cause the electronic device to store the second gain information to the DPD circuit.

10. The electronic device of claim 9, wherein the second gain information comprises a table configured with a gain value for each of the plurality of power levels.

11. A method performed by an electronic device comprising:
obtaining, based on an input signal related to a power amplifier (PA) of the electronic device and an output signal related to the PA, a designated number of samples,
based on the designated number of samples, identifying first gain information of the input signal with respect to the output signal,
with respect to each of power levels of the output signal, performing a first process to average at least a portion of gain values within a designated power range in the first gain information,
with respect to each of power levels of the output signal, performing a second process to estimate gain values out of the designated power range in the first gain information,
based on the first process and the second process, obtaining second gain information of the input signal with respect to the output signal, and
changing setting information of a digital pre-distortion (DPD) circuit of the electronic device according to the second gain information.

12. The method of claim 11, wherein the method further comprises:
performing a sampling process to obtain at least one sample within a sampling interval,
and
performing the sampling process repeatedly until the designated number of samples are obtained.

13. The method of claim 11, wherein the method further comprises:
identifying a plurality of power levels corresponding to a reference power range of the output signal, and
identifying an average value of at least one sampled gain value for each of the plurality of power levels as a gain value for each of the plurality of power levels, and
wherein the at least one sampled gain value is identified using the designated number of samples.

14. The method of claim 11, wherein the method further comprises:
identifying, using a first power level among power levels within the designated power range, a second power level less than the first power level and a third power level greater than the first power level,
identifying gain values for the power levels within the designated power range by identifying an average value of gain values for power levels between the second power level and the third power level as a gain value for the first power level, and
based on identifying the gain values for the power levels within the designated power range, performing the first process.

15. A non-transitory computer readable storage medium storing one or more programs, the one or more programs comprising instructions, which, when executed by a processor of an electronic device with a digital pre-distortion (DPD) circuit, a digital-to-analog converter (DAC) coupled to the DPD circuit, a power amplifier (PA) coupled to the DAC, and an analog-to-digital converter (ADC) coupled to the PA, cause the electronic device to:
obtain, based on an input signal related to the PA and an output signal related to the PA, a designated number of samples,
based on the designated number of samples, identify first gain information of the input signal with respect to the output signal,
with respect to each of power levels of the output signal, perform a first process to average at least a portion of gain values within a designated power range in the first gain information,
with respect to each of power levels of the output signal, perform a second process to estimate gain values out of the designated power range in the first gain information,
based on the first process and the second process, obtain second gain information of the input signal with respect to the output signal, and
change setting information of the DPD circuit according to the second gain information.
